# EUROPEAN PATENT SPECIFICATION

(11) **EP 0 685 125 B1**
(45) Date of publication and mention of the grant of the patent: **20.03.2002**
(21) Application number: 95906040.1
(22) Date of filing: 15.12.1994
(51) Int. Cl.: H03F 1/32, H03F 3/30

(54) **CROSS-CONDUCTION PREVENTION CIRCUIT FOR POWER AMPLIFIER OUTPUT STAGE**
QUERSTROMVERHINDERUNGSSCHALTUNG FÜR LEISTUNGSVERSTÄRKERAUSGANGSSTUFE
CIRCUIT DE PREVENTION DE LA CONDUCTION CROISEE POUR L'ETAGE DE SORTIE D'UN AMPLIFICATEUR DE PUISSANCE

(43) Date of publication of application: 06.12.1995
(73) Proprietor: NATIONAL SEMICONDUCTOR CORPORATION, Sunnyvale, CA 95086-3737 (US)
(72) Inventor: JOHNSON, Nicky, M., Los Altos, CA 94024 (US)
(74) Representative: Horton, Andrew Robert Grant
(86) International application number: US9414696
(87) International publication number: WO9517041

(56) References cited:
- EP-A- 0 297 639
- EP-A- 0 325 299
- DE-A- 4 002 871

## Description

The present invention relates to the design of linear integrated circuits and in particular relates to the design of linear integrated circuits for audio applications, such as audio amplifiers.

The state of the art is represented by DE-A-4002871 and EP-A-0297639 which disclose an audio frequency amplifying system including an output circuit comprising a high side power transistor and a low side power transistor in a push-pull relationship, a high side control circuit and a low side control circuit, each of these control circuits being responsive to an active state of a respective input signal to enable the conduction of the respective power transistor and to provide a respective auxiliary control signal which causes disabling of the conduction of the other power transistor respectively, whereby to inhibit simultaneous conduction of the power transistors. The invention is characterised by, for each of the control circuits, a respective differential transconductance amplifier which in response to a differential input voltage controls two currents and respective means for forming the difference between the respective two currents to provide the respective input signal, the respective auxiliary control signal and also to provide a drive signal for the respective power transistor.

Preferably each of the said control circuits includes a respective transistor which is driven by the respective input signal to provide the respective auxiliary control signal.

Preferably each means for forming the difference between the respective two currents comprises a first current mirror for a first of said currents, and second and third current mirrors for a second of said currents, the third and first current mirrors being connected to form the difference between the respective two currents.

### In the drawings:

Figure 1 shows a monophonic output circuit 100 of a stereo system driving an 8-ohm speaker in a bridge configuration.

Figure 2 shows a typical output section of an amplifier in an audio output circuit.

Figure 3 shows an embodiment of the present invention in an output control circuit.

Figures 4a and 4b show, respectively, in further detail, a high side control circuit and a low side control circuit.

Figure 4c shows a fill-in circuit for providing an output current when the differential voltage at the input leads of the high side control circuit and the low side control circuit is insufficient to turn on either of two power transistors.

Figure 5 shows an audio output circuit in which the embodiment of the present invention shown in Figure 3 is deployed.

Figure 6 shows qualitatively the differential voltage at an output lead and an input lead relative to the output current at the output lead.

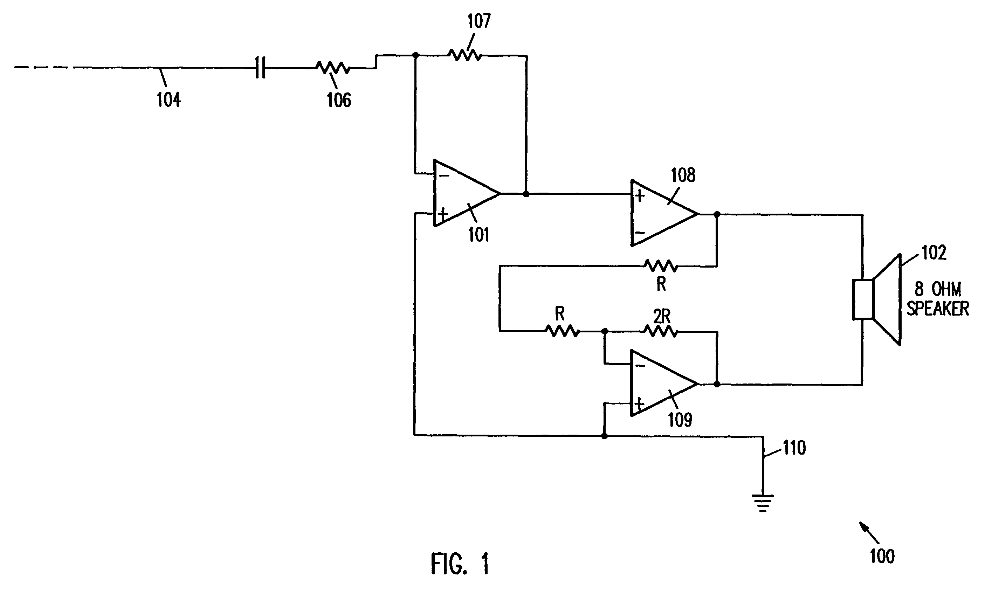

In an audio output circuit, an 8-ohm speaker is typically driven by a pair of power amplifiers in a bridge configuration. Figure 1 shows such a configuration in a monophonic output circuit 100 of an audio system.

As shown in Figure 1, signal 104 is amplified by gain amplifier 101. The output signal of gain amplifier 101 is then amplified by amplifiers 108 and 109 provided in a bridge configuration to drive an 8-ohm speaker 102. Note that the reference voltage on node 110 is voltage between a power supply V_{dd} and a power supply Vₛₛ.

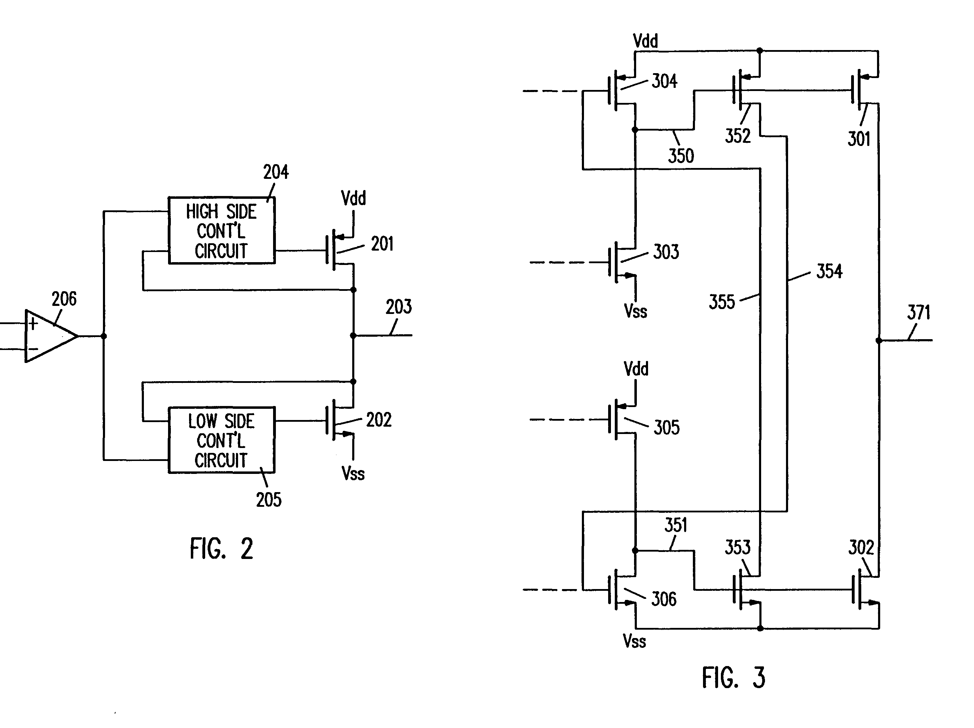

The output current in each of amplifiers 508 and 509 is provided by two power transistors. Figure 2 shows a typical output circuit. As shown in Figure 2, power transistors 201 and 202 are provided to conduct current alternatively from the power supply V_{dd} to output 203, and from output node 203 to power supply Vₛₛ In Figure 2, power transistors 201 and 202 are controlled respectively by high side control circuit 204 and low side control circuit 205, each receiving an input signal from an amplifier 206. To reduce the current drawn by circuit 100 from the power supply and hence reduce the dissipation of circuit 100, only one of power transistors 201 and 202 should be conducting at any given time. Simultaneous conduction is undesirable.

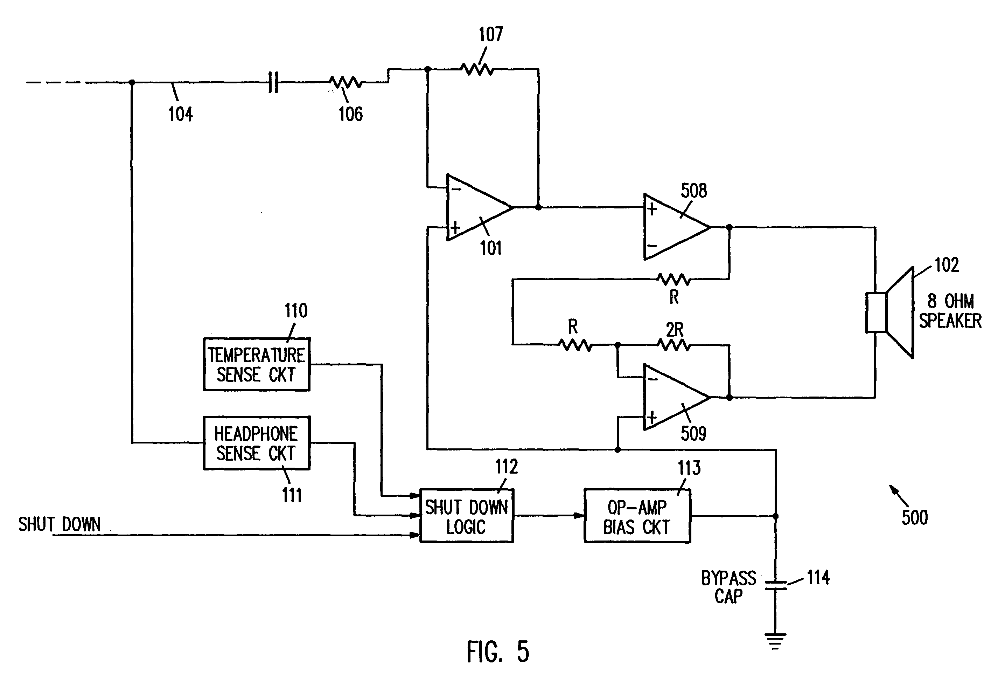

An embodiment of the present invention is deployed in the amplifiers 508 and 509 of an audio output circuit 500 shown in Figure 5. Audio output circuit 500 is similar to audio output circuit 100 shown in Figure 1, except for shut-down logic circuit 112, "op-amp" bias circuit 113, which generates the bias voltages used in amplifiers 508 and 509 and disables output of current to speaker 102, earphone sense circuit 111 and temperature sensing circuit 110. To facilitate reference, like elements in Figures 1 and 5 are provided identical reference numerals. In Figure 5, the output of current to speaker 102 is disabled by bias circuit 113 charging a capacitor 114. Shut-down logic circuit 112, which controls op-amp bias circuit 113, is responsive to a temperature sensing circuit 110 and a headphone sensing circuit 111. The operations of common elements in audio output circuits 100 and 500 already described above with respect to Figure 1 is not repeated.

Figure 3 is a schematic diagram of an embodiment of the present invention in an output control circuit 300 driving power transistors 301 (PMOS) and 302 (NMOS) of an audio output circuit. Control circuit 300 can be implemented, for example, in amplifier 508 or 509 of the audio output circuit 500 shown in Figure 5. In Figure 3, transistor 303 and 304 form an output stage of a high side control circuit 375, providing a control signal on lead 350 to control power transistor 301. Similarly, transistors 305 and 306 form an output stage of a low side control circuit 376, providing a control signal on lead 351 to control power transistor 302. Control signals on leads 350 and 351 are each also provided to control, respectively, NMOS transistor 352 and NMOS transistor 353. As shown in Figure 3, the drain terminal 354 is coupled to the gate terminal of transistor 306 in the output stage of low side control circuit 376. Likewise, the drain terminal of NMOS transistor 353 is coupled to transistor 304 in the output stage of high side control circuit 375.

In the configuration of Figure 3, when the voltage of the control signal on lead 350 decreases, both power transistor 301 and PMOS transistor 352 are turned on simultaneously. Consequently, the voltage on lead 354 is rapidly pulled to supply V_{dd}'s voltage, to turn on transistor 306 in the output stage of low side control circuit 376, thereby pulling the voltage of the control signal on lead 351 towards power supply Vₛₛ's voltage to shut off transistor 302. In the same manner, when the voltage of the control signal on lead 351 increases, both power transistor 302 and NMOS transistor 353 are turned on simultaneously. Consequently, the voltage on lead 355 is pulled towards power supply vₛₛ's voltage to turn on transistor 304 of high side control circuit 375. Consequently, the voltage of the control signal on lead 350 is pulled towards power supply V_{dd}'s voltage, thereby turning off power transistor 301.

Thus, under the configuration of Figure 3, when power transistor 301 is turned on, the action of transistor 352 turns off power transistor 302. Conversely, when power transistor 302 is turned on, the action of transistor 353 turns off power transistor 301. In this manner, Figure 3's embodiment of the present invention ensures that power transistors 301 and 302 are not turned on simultaneously.

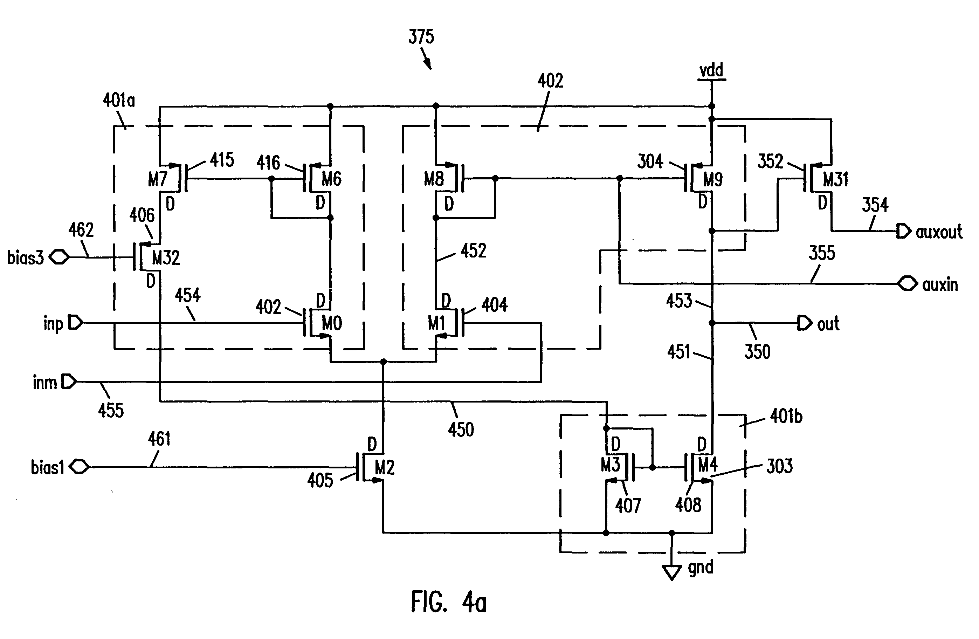

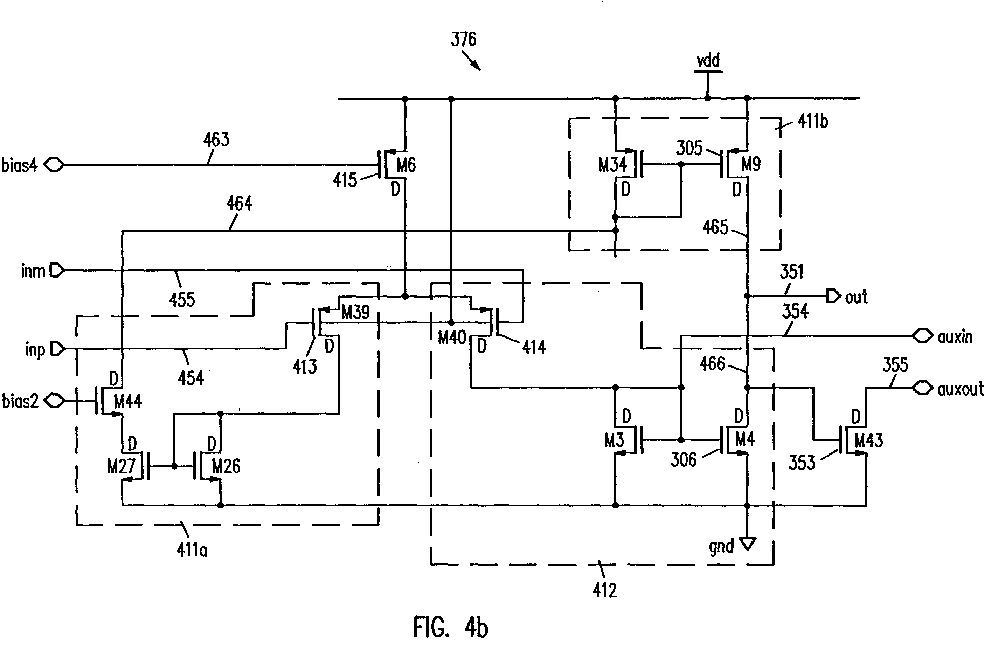

Figures 4a and 4b show, respectively, in further detail, high side control circuit 375 and low side control circuit 376. To facilitate the description, corresponding structures in Figures 3, 4a and 4b are given the same reference numerals.

As shown in Figure 4a, in this embodiment, transistors 303 and 304 of the output stage of high side control circuit 375 are provided drawn W/L (channel width to channel length) ratios of 150/2 and 50/2. Under one CMOS process, a transistor having a 150/2 W/L ratio is fabricated as a transistor having a channel width of 120 microns and a channel length of 1.6 microns (i.e. a 0.8 shrink). Transistor 352 is shown to have a W/L ratio of 250/1. High side control circuit 375 includes a differential transconductance amplifier formed by transistor 405 (W/L=100/2), circuits 401a, 401b and 402. Transistor 405 is biased by a bias voltage on lead 405 to act as a current source for differential transconductance amplifier 475. The differential transconductance amplifier is responsive to the differential voltage of leads 454 and 455, respectively controlling the currents in transistors 403 and 404. Transistors 403 and 404 are respectively given W/L ratios of 75/2 and 100/2 to provide a built-in bias.

The current in transistor 403, responsive to the voltage on lead 454, is reflected in circuit 401a to lead 450, which is in turn reflected in circuit 401b to provide an equivalent current through transistor 303 in lead 451. The current in transistor 404, responsive to the voltage on lead 455, is reflected in circuit 402 to provide an equivalent current through transistor 304 to lead 453. Thus, the output current on lead 350 is the difference between the currents through transistor 403 and 404, which correspond substantially to the differential voltage on leads 454 and 455. The output current in lead 350 also drives transistor 352, which provides a signal on lead 354 to low side control circuit 376 to turn off power transistor 302. Transistor 406 equalizes the drain voltages of transistors 415 and 416 to improve the performance of the current mirror in circuit 401ab.

Low side control circuit 376 also includes a differential transconductance amplifier 476 also responsive to the differential voltage on leads 454 and 455. Differential transconductance amplifier 476 consists of transistor 463, which acts as a current source adjustable by a bias voltage on lead 463, and circuits 411a, 411b and 412. The voltage on lead 454 causes a current in transistor 413; this current in transistor 413 is reflected by circuits 411a and 411b to provide an equivalent current through transistor 305 in lead 465. Similarly, the voltage on lead 455 causes a current in transistor 414; this current in transistor 414 is reflected in circuit 412 to provide an equivalent current in lead 466 through transistor 306. Thus, the current in output lead 351 is the difference between the currents in transistors 413 and 414. The current in output lead 351 corresponds substantially to the differential voltage of leads 454 and 455. The output current in lead 351 is also used to drive transistor 353, which provides a signal on lead 355 to high side control circuit 375 to turn off power transistor 301.

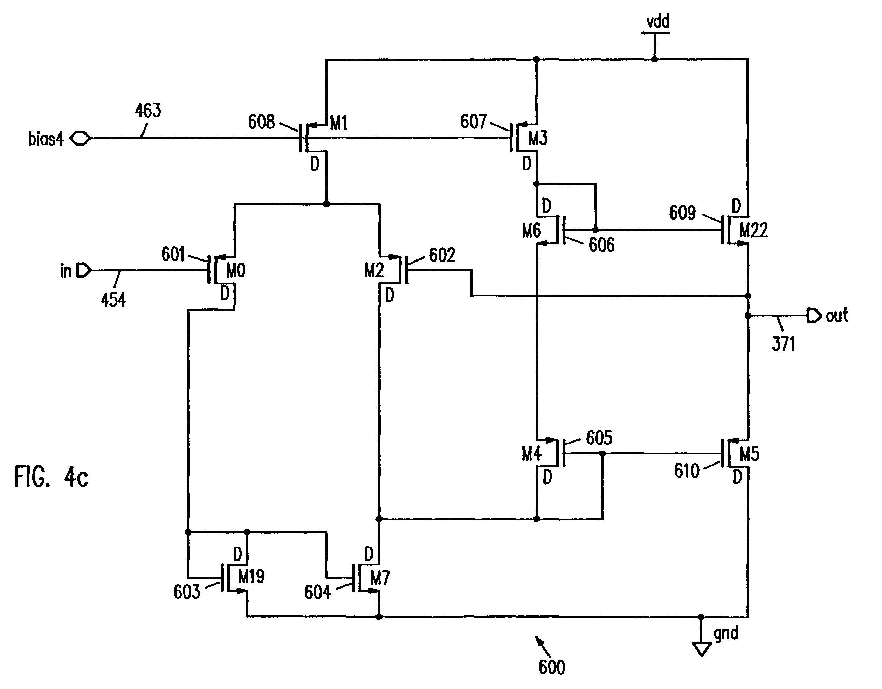

Because there is a region within which the differential voltage on leads 454 and 455 is insufficient to turn on either power transistor 301 or 302 through high side or low side control circuits 375 and 376, a fill-in circuit is provided. This fill-in circuit provides a linear current for the region in which the differential voltage on leads 454 and 455 is insufficient to turn on either power transistor 301 or 302. An example of such a fill-in circuit, fill-in circuit 600, is shown in Figure 4c.

In Figure 4c, circuit 600 includes a differential amplifier with negative feedback formed by transistors 601 and 602, which receives a differential voltage between output lead 371 and input lead 454. Operationally, the current flowing in both transistor 601 (W/L=250/2) and transistor 603 (W/L=50/2) is reflected and amplified by a factor of three (due to relative device sizes) onto transistor 604 (W/L=150/2). When the differential voltage between output lead 371 and input lead 454 is close to zero volts, the current in transistor 602 (W/L=250/2) is substantially the same as the current in transistor 601, which is half the current flowing in transistor 608 (W/L=250/2). Since the current in transistor 604 is the sum of the currents in transistors 602 and 605, the current in transistor 605, which flows in transistors 606 (W/L=50/1) as well, is twice the current in transistor 601, or the substantially the same current as the current in transistor 608. The current in transistor 606 is reflected and amplified by a factor of two to transistor 609 (W/L=100/1). If the voltage on input lead increases relative to the voltage on input lead 371 (i.e. > 0), the current in transistor 601 increases. In response, the currents in transistors 606 and 609 increases to increase the output current. Conversely, if the voltage on input lead 454 falls below the voltage on output lead 371, the currents in transistors 606 and 609 decreases to decrease the output current.

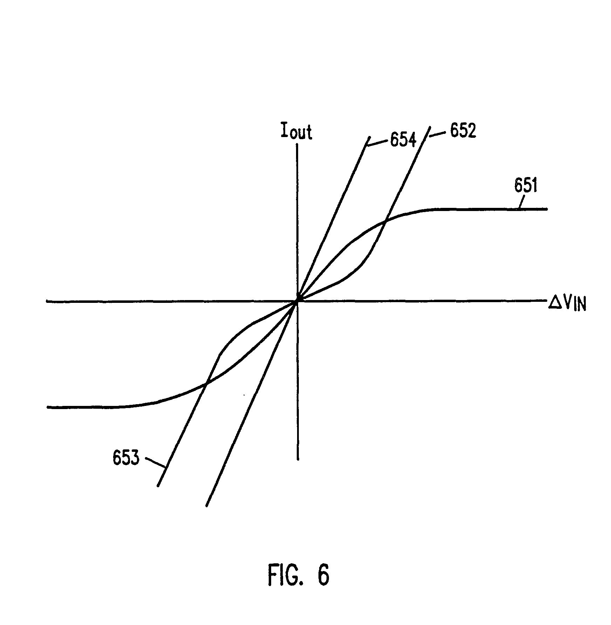

The current characteristic at output lead 371 described above is shown qualitatively in Figure 6. Figure 6 shows qualitatively the output current 651 at output lead 371 relative to the differential voltage between input lead 454 and output lead 371. The output current characteristics 652 and 653 of circuits 375 and 376, respectively, are also qualitatively shown in Figure 6. Current characteristic 654 is the sum of current characteristics 651, 652 and 653, illustrating a relatively linear output current over the operating range of amplifier 508.

As shown in Figure 6, in the region where the differential voltage on input and output leads 454 and 371 is close to zero volts, a current substantially proportional to this differential voltage is provided at output lead 371. However, when this differential voltage becomes large, i.e. when either power transistor 301 or 302 is on, the current sources provided by transistors 607 and 608 are substantially saturated, leading to a substantially constant output current contribution by circuit 600 at lead 371. The remaining of the current in current characteristic 654 is provided by the conducting one of transistors 302 and 301.

The above detailed description is provided to illustrate the specific embodiments of the present invention and is not intended to be limiting. Many modifications and variations within the scope of the present invention are possible. The present invention is defined by the following claims.

## Claims

1. An audio frequency amplifying system including an output circuit comprising a high side power transistor (301) and a low side power transistor (302) in a push-pull relationship, a high side control circuit (304, 352) and a low side control circuit (306, 353), each of these control circuits being responsive to an active state of a respective input signal (350; 351) to enable the conduction of the respective power transistor and to provide a respective auxiliary control signal (354; 355) which causes disabling of the conduction of the other power transistor respectively, whereby to inhibit simultaneous conduction of the power transistors, **characterised by**, for each of the control circuits, a respective differential transconductance amplifier (403, 404; 413, 414), which in response to a differential input voltage controls two currents and respective means (401a, 401b, 402; 411a, 411b, 412) for forming the difference between the respective two currents to provide the respective input signal (350, 351), the respective auxiliary control signal (354,355) and also to provide a drive signal for the respective power transistor (301, 302).

2. A system according to claim 1, wherein each of the said control circuits includes a respective transistor (352, 353) which is driven by the respective input signal (350, 351) to provide the respective auxiliary control signal (354, 355).

3. A system according to claim 1 or claim 2 wherein each of the said means comprises a first current mirror (401a; 411a) for a first of said currents, and second (402; 412) and third (401b; 411b) current mirrors for a second of said currents, the third and first current mirrors being connected to form the difference between the respective two currents.

## Patentansprüche

1. Tonfrequenzverstärkungssystem mit einer Ausgangsschaltung mit einem Hochseiten-Leistungstransistor (301) und einem Niederseiten-Leistungstransistor (302) in einer Gegentaktbeziehung, einer Hochseiten-Steuerschaltung (304, 352) und einer Niederseiten-Steuerschaltung (306, 353), wobei jede dieser Steuerschaltungen auf einen aktiven Zustand eines jeweiligen Eingangssignals (350; 351) reagiert, um die Leitung des jeweiligen Leistungstransistors freizugeben und ein jeweiliges Hilfssteuersignal (354; 355) zu liefern, das jeweils die Sperrung der Leitung des anderen Leistungstransistors bewirkt, um dadurch eine gleichzeitige Leitung der Leistungstransistoren zu unterbinden, **gekennzeichnet durch** einen jeweiligen Transkonduktanzdifferenzverstärker (403, 404; 413, 414) für jede der Steuerschaltungen, der als Reaktion auf eine Differenzeingangsspannung zwei Ströme steuert, und jeweilige Mittel (401a, 401b, 402; 411a, 411b, 412) zum Erzeugen der Differenz zwischen den jeweiligen zwei Strömen, um das jeweilige Eingangssignal (350, 351), das jeweilige Hilfssteuersignal (354, 355) und auch ein Ansteuersignal für den jeweiligen Leistungstransistor (301, 302) zu liefern.

2. System nach Anspruch 1, wobei jede der Steuerschaltungen einen jeweiligen Transistor (352, 353) umfaßt, der durch das jeweilige Eingangssignal (350, 351) angesteuert wird, um das jeweilige Hilfssteuersignal (354, 355) zu liefern.

3. System nach Anspruch 1 oder Anspruch 2, wobei jedes der Mittel einen ersten Stromspiegel (401a; 411a) für einen ersten der Ströme und einen zweiten (402; 412) und einen dritten (401b; 411b) Stromspiegel für einen zweiten der Ströme umfaßt, wobei der dritte und der erste Stromspiegel verbunden sind, um die Differenz zwischen den jeweiligen zwei Strömen zu erzeugen.

## Revendications

1. Système d'amplification audiofréquence comprenant un circuit de sortie comportant un transistor de puissance (301) de côté haut et un transistor de puissance (302) de côté bas dans un montage symétrique, un circuit de commande (304, 352) de côté haut et un circuit de commande (306, 353) de côté bas, chacun de ces circuits de commande réagissant à un état actif d'un signal d'entrée respectif (350, 351) en autorisant la conduction du transistor de puissance respectif et en produisant un signal de commande auxiliaire respectif (354 ; 455) qui provoque l'interdiction de la conduction de l'autre transistor de puissance, respectivement, de façon à empêcher la conduction simultanée des transistors de puissance, **caractérisé par**, pour chacun des circuits de commande, un amplificateur respectif à transconductance différentielle (403, 404 ; 413, 414) qui, en réponse à une tension d'entrée différentielle, commande deux courants et des moyens respectifs (401a, 401b, 402 ; 411a, 411b, 412) destinés à former la différence entre les deux courants respectifs pour produire le signal d'entrée respectif (350, 351), le signal de commande auxiliaire respectif (354, 355) et pour produire aussi un signal d'attaque pour le transistor de puissance respectif (301, 302).

2. Système selon la revendication 1, dans lequel chacun desdits circuits de commande comprend un transistor respectif (352, 353) qui est attaqué par le signal d'entrée respectif (350, 351) pour produire le signal de commande auxiliaire respectif (354, 355).

3. Système selon la revendication 1 ou la revendication 2, dans lequel chacun desdits moyens comporte un premier miroir de courant (401a ; 411a) pour un premier desdits courants, et des deuxième (402 ; 412) et troisième (401b ; 411b) miroirs de courant pour un second desdits courants, les troisième et premier miroirs de courant étant connectés pour former la différence entre les deux courants respectifs.
